# EUROPÄISCHE PATENTSCHRIFT

(11) **EP 2 130 235 B1**
(45) Veröffentlichungstag und Bekanntmachung des Hinweises auf die Patenterteilung: **06.03.2019**
(21) Anmeldenummer: 08700869.4
(22) Anmeldetag: 17.01.2008
(51) Int. Cl.: H01L 33/14, H01L 33/38, H01L 33/40, H01L 33/22, H01L 33/44

(54) **LEUCHTDIODENCHIP MIT METALLISCHER SPIEGELSCHICHT, DURCHKONTAKTIERUNG, TUNNELKONTAKT UND LADUNGSTRÄGERRESERVOIR**
LIGHT-EMITTING DIODE CHIP WITH A METAL REFLECTIVE LAYER, THROUGH CONTACT, TUNNEL CONTACT AND A CHARGE CARRIER CONTACT
PUCE OPTOÉLECTRONIQUE AVEC UNE COUCHE MÉTALLIQUE RÉFLÉCHISSANTE, CONTACT TRAVERSANT, CONTACT TUNNEL ET CONTACT PORTEUR DE CHARGE

(30) Priorität: 23.01.2007 DE 102007003282
(43) Veröffentlichungstag der Anmeldung: 09.12.2009
(73) Patentinhaber: OSRAM Opto Semiconductors GmbH, 93055 Regensburg (DE)
(72) Erfinder: SABATHIL, Matthias, 93059 Regensburg (DE); HÖPPEL, Lutz, 93087 Alteglofsheim (DE); EICHLER, Christoph, 93105 Tegernheim (DE); ENGL, Karl, 93051 Regensburg (DE); PETER, Matthias, 93087 Alteglofsheim (DE); STRASSBURG, Martin, 93105 Tegernheim (DE)
(74) Vertreter: Epping - Hermann - Fischer
(86) Internationale Anmeldenummer: PCT/DE2008/000081
(87) Internationale Veröffentlichungsnummer: WO 2008/089728

(56) Entgegenhaltungen:
- EP-A- 0 886 326
- EP-A- 1 387 414
- WO-A-98/07218
- WO-A-2006/138465
- DE-A1- 19 648 309
- DE-A1- 19 954 343
- DE-A1- 19 957 312
- DE-A1-102004 050 891
- DE-A1-102004 061 865
- US-A1- 2002 101 894
- US-A1- 2003 111 667
- US-A1- 2003 123 505
- US-A1- 2005 269 588
- US-B1- 6 549 556

## Beschreibung

Es wird ein Leuchtdiodenchip, d. h. ein optoelektronischer Halbleiterchip, angegeben.

Die Druckschrift US 6 549 556 B1 zeigt eine Laserdiode.

Die Druckschriften US 2003/111667 A1, DE 10 2004 061 865 A1, DE 10 2004 050 891 A1 und DE 199 57 312 A1 betreffen Leuchtdioden oder Leuchtdiodenchips. DE 10 2004 050 891 A1 offenbart einen Leuchtdiodenchip mit einer Schichtenfolge, die eine erste n-leitende Schicht und eine zweite n-leitende Schicht umfasst, wobei zwischen der ersten und der zweiten n-leitenden Schicht eine p-leitende Schicht und eine strahlungserzeugende aktive Zone angeordnet sind, mit einem Spiegel, der eine Spiegelschicht umfasst, mit einer Aussparung, die sich vertikal durch die erste n-leitende Schicht, durch die aktive Zone und die p-leitende Schicht bis hin zur zweiten n-leitenden Schicht erstreckt, mit einer Durchkontaktierung, die in der Aussparung angeordnet ist, wobei die erste n-leitende Schicht dem Spiegel zugewandt ist, wobei die elektrisch leitende Spiegelschicht leitend mit der ersten n-leitenden Schicht verbunden ist und wobei die Durchkontaktierung mit der zweiten n-leitenden Schicht leitend verbunden ist.

Eine zu lösende Aufgabe besteht darin, einen Leuchtdiodenchip mit hoher Strahlungseffizienz anzugeben, der niedrige Verluste aufweist.

Die vorliegende Erfindung bezieht sich auf einem Leuchtdiodenchip gemäß Anspruch 1 oder 10. Weitere Ausgestaltungen der Erfindung gehen aus den Unteransprüchen hervor.

Gemäß einer ersten bevorzugten Ausführungsform wird ein Leuchtdiodenchip mit einer Schichtenfolge angegeben, die mindestens eine n-leitende Schicht aufweist, wobei die mindestens eine n-leitende Schicht eine erste n-leitende Schicht und eine zweite n-leitende Schicht umfasst, wobei zwischen der ersten und der zweiten n-leitenden Schicht eine p-leitende Schicht und eine strahlungserzeugende aktive Zone angeordnet sind. Der Leuchtdiodenchip umfasst einen Spiegel, der mit der Schichtenfolge fest verbunden ist. Der Spiegel weist eine leitend mit der n-leitenden Schicht verbundene, elektrisch leitende Spiegelschicht auf. Der Spiegel umfasst ferner mindestens eine dielektrische Schicht, die zwischen der n-leitenden Schicht und der elektrisch leitenden Spiegelschicht angeordnet ist. Die dielektrische Schicht ist vorzugsweise transparent. Ferner umfasst der Leuchtdiodenchip eine Aussparung, die sich vertikal von der Spiegelschicht durch die erste n-leitende Schicht, durch die aktive Zone und die p-leitende Schicht bis hin zur zweiten n-leitenden Schicht erstreckt. Eine zweite Durchkontaktierung ist in der Aussparung angeordnet. Die erste n-leitende Schicht ist dabei dem Spiegel zugewandt.

Der Brechungsindex der dielektrischen Schicht ist kleiner als derjenige der an die dielektrische Schicht angrenzenden Schicht der Schichtenfolge. Durch die Verwendung der dielektrischen Schicht mit einem kleinen Brechungsindex können die auf die dielektrische Schicht flach einfallenden Strahlungskomponenten vollständig reflektiert werden. Somit ist es sogar möglich, eine Ag-freie Spiegelschicht einzusetzen. Ein silberfreier Spiegel enthält beispielsweise Al, Rh, Rt. Somit gelingt es, die Feuchtestabilität sowie die Langzeitstabilität des Chips zu erhöhen.

Die mindestens eine dielektrische Schicht weist in einer Variante mindestens zwei übereinander angeordnete Schichten mit unterschiedlich großen Brechungsindizes auf, die zusammen einen Bragg-Spiegel bilden. Bei mehr als zwei dielektrischen Schichten sind die Schichten mit einer relativ hohen und einer relativ niedrigen Brechzahl in abwechselnder Reihenfolge angeordnet. Die Dicke der jeweiligen Schicht beträgt vorzugsweise eine Viertelwellenlänge der in der aktiven Zone erzeugten Strahlung. Das Verhältnis der Brechzahlen der aufeinander folgenden Schichten beträgt vorzugsweise mindestens 1,25.

Der Spiegel kann alternativ eine Abfolge von dielektrischen und elektrisch leitenden Schichten aufweisen, wobei die Schichten mit einer relativ hohen und einer relativ niedrigen Brechzahl in abwechselnder Reihenfolge angeordnet sind.

Bei der Variante mit dem Bragg-Spiegel ist es möglich, eine elektrisch leitende Spiegelschicht zu verwenden, deren Reflektivität nicht besonders hoch ist, wobei sie z. B. 95% nicht übersteigt.

Die jeweilige n-leitende Schicht der Schichtenfolge kann durch die dielektrische Schicht oder die dielektrischen Schichten des Bragg-Spiegels hindurch z. B. über vertikale elektrische Verbindungen kontaktiert werden. Die vertikalen elektrischen Verbindungen werden nachstehend als Durchkontaktierungen bezeichnet.

Erfindungsgemäß weist die Schichtenfolge eine erste und eine zweite n-leitenden Schicht auf. Die Schichtenfolge weist eine p-leitende Schicht auf, die zwischen den beiden n-leitenden Schichten angeordnet ist (npn-Schichtaufbau). Die n-leitenden Schichten sind vorzugsweise die endständigen Schichten der Schichtenfolge. Zumindest ist die aktive Zone und die p-leitende Schicht zwischen den beiden n-leitenden Schichten angeordnet.

Die erste n-leitende Schicht ist eine an die strahlungserzeugende aktive Zone angrenzende Schicht. Die zweite n-leitende Schicht bildet einen Tunnelkontakt mit der p-leitenden Schicht der Schichtenfolge. Die erste und zweite n-leitende Schicht können in allen Ausführungsbeispielen gegeneinander ausgetauscht werden. Dies bedeutet, dass die Reihenfolge der Schichten der Schichtenfolge bei fixer Lage des Spiegels umgedreht werden kann.

Der Spiegel ist entweder mit der ersten oder mit der zweiten n-leitenden Schicht leitend verbunden. Die dielektrische Schicht ist in einer Variante zwischen der ersten n-leitenden Schicht und der Spiegelschicht angeordnet. Die dielektrische Schicht ist in einer weiteren Variante zwischen der zweiten n-leitenden Schicht und der Spiegelschicht angeordnet.

Mindestens eine der n-leitenden Schichten wird als eine Kontaktschicht benutzt. Als Kontaktschicht wird eine Schicht bezeichnet, die durch einen Anschlussdraht kontaktiert wird, der an eine Stromquelle angeschlossen ist. In einer Variante werden beide n-leitenden Schichten als jeweils eine Kontaktschicht benutzt. Alternativ kann eine der n-leitenden Schichten als eine erste Kontaktschicht und die Spiegelschicht als eine zweite Kontaktschicht benutzt werden.

Gemäß einer Abwandlung wird ein Leuchtdiodenchip mit einer Schichtenfolge angegeben, die in einer Wachstumsrichtung in der angegebenen Reihenfolge aufeinander folgende Schichten aufweist: eine erste n-leitende Schicht, eine strahlungserzeugende aktive Zone, eine p-leitende Schicht und eine zweite n-leitende Schicht. Zwischen der p-leitenden Schicht und der zweiten n-leitenden Schicht ist ein Tunnelkontakt gebildet.

Die zweite n-leitende Schicht dient als eine Stromaufweitungsschicht, die an eine Stromquelle angeschlossen wird. Durch die Einführung der Stromaufweitungsschicht kann der Spiegel vom elektrischen Kontakt entkoppelt werden. Dadurch wird es zum einen ermöglicht, einen hochreflektierenden Spiegel mit einer dielektrischen Schicht zu verwenden, und zum anderen kann der Kontaktwiderstand beim Kontaktieren der Schichtenfolge in hohem Maße reduziert werden. Somit kann die Gesamteffizienz des Leuchtdiodenchips deutlich erhöht werden.

Gemäß der Erfindung wird ein Leuchtdiodenchip mit einer Schichtenfolge angegeben, die zwei Schichten des gleichen Leitfähigkeitstyps aufweist, zwischen denen eine strahlungserzeugende aktive Zone angeordnet ist.

Die zwei Schichten des gleichen Leitfähigkeitstyps weisen eine erste Schicht und eine zweite Schicht des ersten Leitfähigkeitstyps auf, wobei die vorzugsweise relativ dünne zweite Schicht des ersten Leitfähigkeitstyps als ein Ladungsträger-Reservoir zur Erhöhung der Ladungsträgerkonzentration des ersten Leitfähigkeitstyps in der Nähe der aktiven Zone vorgesehen ist. Die Schichtenfolge weist eine Schicht des zweiten Leitfähigkeitstyps auf, die an die zweite Schicht des ersten Leitfähigkeitstyps angrenzt. Der erste Leitfähigkeitstyp ist n-Typ und der zweite Leitfähigkeitstyp p-Typ.

Die Schichtenfolge weist in einer Variante eine weitere Schicht des zweiten Leitfähigkeitstyps auf, die mit der ersten Schicht des ersten Leitfähigkeitstyps einen Tunnelkontakt bildet.

Die Wachstumsrichtung bei der Erzeugung der Schichtenfolge kann im Prinzip beliebig sein.

Die Dicke der zweiten Schicht des ersten Leitfähigkeitstyps ist vorzugsweise kleiner als diejenige der ersten Schicht. Die Dicke der zweiten Schicht beträgt vorzugsweise maximal 20% derjenigen der ersten Schicht. Die zweite Schicht des ersten Leitfähigkeitstyps ist vorzugsweise maximal 20 nm dick.

Gemäß einer zweiten Ausführungsform wird ein Leuchtdiodenchip angegeben mit einer Schichtenfolge, die folgende Schichten aufweist: zwei n-leitende Schichten, eine strahlungserzeugende aktive Zone und eine p-leitende Schicht. Auf der in Auskopplungsrichtung obersten der n-leitenden Schichten ist eine Anschlussfläche angeordnet. In der Schichtenfolge ist zumindest unterhalb der Anschlussfläche eine Aussparung ausgebildet, die sich in Auskopplungsrichtung zumindest bis zur obersten der n-leitenden Schichten erstreckt. Die Aussparung ist zumindest im Bereich ihrer Mantelflächen durch ein dielektrisches Material ausgekleidet. Der Boden der Aussparung ist in Vertikalrichtung von der Anschlussfläche beabstandet.

Ferner kann die Aussparung beispielsweise in Form eines Sacklochs oder in Form einer Ringaussparung ausgeführt sein. Eine Aussparung, die in Form eines Sacklochs ausgeführt ist, weist zum Beispiel eine zylinderförmige Ausführung auf. Eine Ringaussparung weist die Form eines Zylindermantels auf, wobei die Schichtenfolge in dem Innenbereich nicht ausgespart ist. Das hat den Vorteil, dass der Leuchtdiodenchip keine großflächige Aussparung aufweist, welche sich negativ auf die Stabilität des Leuchtdiodenchips auswirken könnte.

In der Aussparung ist in einer Variante eine Durchkontaktierung zur elektrischen Kontaktierung der in Auskopplungsrichtung obersten der n-leitenden Schichten angeordnet.

Die Schichtenfolge ist vorzugsweise mit einem Spiegel fest verbunden, der zumindest eine elektrisch leitfähige Spiegelschicht aufweist, die vorzugsweise mit einer der n-leitenden Schichten der Schichtenfolge elektrisch verbunden ist. Der Spiegel kann darüber hinaus eine transparente dielektrische Schicht umfassen, die zwischen der Spiegelschicht und der Schichtenfolge angeordnet ist.
In der dielektrischen Schicht ist in einer Variante eine Durchkontaktierung zur elektrischen Kontaktierung der in Auskopplungsrichtung untersten der n-leitenden Schichten angeordnet.

Nachstehend werden vorteilhafte Ausgestaltungen des Leuchtdiodenchips erläutert.

Der Leitfähigkeitstyp der Schichten der Schichtenfolge kann z. B. n-Typ oder p-Typ sein. In einer Halbleiterschicht mit der Leitfähigkeit des n-Typs sind die Elektronen und in einer Halbleiterschicht mit der Leitfähigkeit des p-Typs die Löcher die Majoritätsladungsträger.

Die Schichten mit der Leitfähigkeit des n-Typs werden als n-leitende Schichten und die Schichten mit der Leitfähigkeit des p-Typs als p-leitende Schichten bezeichnet.

Die Schichtenfolge umfasst eine p-leitende Schicht und eine strahlungserzeugende aktive Zone, die zwischen der p-leitenden Schicht und der ersten n-leitenden Schicht angeordnet.

Die Schichten der Schichtenfolge sind vorzugsweise epitaktisch aufgewachsen. Die Schichtenfolge ist beispielsweise auf der Basis von GaN gebildet. Die aktive Zone ist in einer Variante durch eine Schicht gebildet, die InGaN oder InGaAlN enthält. Der In-Gehalt beträgt vorzugsweise bis 50%. Der genaue Spektralbereich der in der aktiven Zone erzeugten Strahlung hängt vom In-Gehalt ab und kann im Prinzip beliebig sein. Zur Erzeugung eines Weißlichtes kann auf der Auskoppelseite ein Converter vorgesehen sein.

Die Schichtenfolge weist in einer Abwandlungeine p-leitende Schicht, eine weitere p-leitende Schicht und eine zwischen den p-leitenden Schichten angeordnete strahlungserzeugende aktive Zone auf. Die weitere p-leitende Schicht ist zwischen der aktiven Zone und der ersten n-leitenden Schicht angeordnet. Die Dicke der weiteren p-leitenden Schicht beträgt beispielsweise 0,1 nm bis 100 nm, in einer Variante 0,1 nm bis 10 nm. Der Mindestwert für Dotierung bei der weiteren p-leitenden Schicht beträgt vorzugsweise 10¹⁸ Mg-Atome pro cm³.

Die Schichtenfolge umfasst erfindungsgemäß eine zweite n-leitende Schicht. Die p-leitende Schicht ist vorzugsweise zwischen der zweiten n-leitenden Schicht und der aktiven Zone angeordnet. Zwischen der p-leitenden Schicht und der zweiten n-leitenden Schicht ist ein Tunnelkontakt gebildet.

Die Spiegelschicht ist mit der ersten n-leitenden Schicht über mindestens eine erste Durchkontaktierung, in einer vorteilhaften Variante über mehrere Durchkontaktierungen, die in der dielektrischen Schicht angeordnet sind, leitend verbunden.

Mit mehreren Durchkontaktierungen gelingt es, den Kontaktwiderstand zu reduzieren und somit den Potentialunterschied zwischen der Spiegelschicht und der leitend mit ihr verbundenen n-leitenden Schicht gegenüber der Variante mit nur einer Durchkontaktierung zu verringern. An der Grenzfläche der jeweiligen ersten Durchkontaktierung und der n-leitenden Schicht ist ein vorzugsweise niederohmiger elektrischer Kontakt gebildet. Die Gesamtfläche dieser Kontakte beträgt vorzugsweise maximal 10%, in einer vorteilhaften Variante maximal 5% der Grundfläche der Schichtenfolge.

Der laterale Abstand zwischen den ersten Durchkontaktierungen beträgt vorzugsweise 20-30 Mikrometer, was gegenüber der Dicke der dielektrischen Schicht, die beispielsweise 10 bis 2000 nm, in einer bevorzugten Variante 400-600 nm beträgt, relativ groß ist.

Die dielektrische Schicht wirkt für Strahlungskomponenten, die einen relativ flachen Einfallswinkel - beispielsweise über 30° - aufweisen, als ein nahezu perfekter Spiegel, dessen Reflexionskoeffizient annähernd 100% beträgt (Totalreflexion). Da bei der Totalreflexion an der dielektrischen Schicht keine Absorption stattfindet, können Absorptionsverluste für die flachen Einfallswinkel praktisch ausgeschlossen werden.

Die dielektrische Schicht ist für die in der aktiven Zone erzeugte Strahlung vorzugsweise transparent. Die Strahlungskomponenten, die im Wesentlichen senkrecht auf die Grenzfläche der dielektrischen Schicht und der an diese angrenzenden n-leitenden einfallen, werden im Wesentlichen nicht an dieser Grenzfläche, sondern an der Grenzfläche der dielektrischen Schicht und der Spiegelschicht reflektiert.

Der Brechungsindex der dielektrischen Schicht ist vorzugsweise um mindestens einen Faktor 1,5 kleiner als derjenige der zu ihr gewandten Schicht der Schichtenfolge, z. B. der ersten oder zweiten n-leitenden Schicht. Als Materialien für die dielektrische Schicht kommen insbesondere Siliziumdioxid, Siliziumnitrid und Spin-On Glas in Betracht. Weitere transparente, in einer Variante poröse, dielektrische Materialien, deren Brechungsindex kleiner als 1,5 ist, sind auch geeignet. Vorteilhaft sind transparente poröse Materialien, deren Brechungsindex annähernd demjenigen der Luft gleich ist.

Der Gewinn an Auskoppeleffizienz durch die Verwendung der dielektrischen Schicht mit der Brechzahl 1,5 beträgt mindestens 10% gegenüber der Variante mit einem Spiegel, der nur Metallschichten, d. h. keine dielektrische Schicht, aufweist.

Die Spiegelschicht enthält vorzugsweise Metall, z. B. Al, Ag, PtAg und/oder andere geeignete Metalle oder Metalllegierungen, inklusive deren Kombination. Die Dicke der Pt-Schicht bei PtAg beträgt vorzugsweise maximal 3 nm, in einer vorteilhaften Variante maximal 0,3 nm.

Durch den Einsatz der dielektrischen Schicht werden die Unterschiede in der Auskoppeleffizienz für Spiegelschichten aus unterschiedlichen Materialien nahezu beseitigt. Somit ist es möglich, den Silbergehalt in der Spiegelschicht zu reduzieren und den Aluminiumanteil zu erhöhen. Auf Ag kann unter Umständen sogar komplett verzichtet werden.

Die Spiegelschicht kann durch das Aufdampfen oder Abscheiden eines Metalls hergestellt werden. Die Durchkontaktierungen und/oder eine strukturierte Spiegelschicht können auch durch das Aufdampfen oder Abscheiden eines Metalls unter Verwendung einer geeigneten Maske hergestellt werden.

Die zweite n-leitende Schicht ist in einer vorteilhaften Variante als eine Auskoppelschicht zur Auskopplung der in der aktiven Zone erzeugten Strahlung vorgesehen. Auf der zweiten n-leitenden Schicht ist vorzugsweise eine Anschlussfläche angeordnet, die von außen z. B. durch einen Anschlussdraht kontaktierbar ist.

Die frei liegende Oberfläche der zweiten n-leitenden Schicht ist vorzugsweise aufgeraut. Anstelle der Aufrauung kann auf der Oberfläche der zweiten n-leitenden Schicht eine andere Auskoppelstruktur wie z. B. photonische Kristall- oder Quasikristallstrukturen mit einer periodischen Anordnung von Unebenheiten der Oberfläche angeordnet sein. Nichtperiodische Auskoppelstrukturen kommen auch in Betracht. Z. B. kann an dieser Stelle eine zusätzliche zumindest teilweise transparente Schicht mit einer rauhen Oberfläche vorgesehen sein. Eine matte Schicht kommt auch in Betracht.

Die mit einer aufgerauten Oberfläche nicht identischen Auskoppelstrukturen können z. B. Vertiefungen der Tiefe 100 bis 1000 nm, vorzugsweise 150 bis 500 nm darstellen. Die Vertiefungen können einen kreisrunden oder rechteckigen, insbesondere quadratischen Querschnitt aufweisen. Der Durchmesser bzw. die lineare Querschnittsgröße der Vertiefung beträgt in einer Variante 50 bis 800 nm, vorzugsweise 80 bis 500 nm.

Nicht nur die n-leitende, sondern auch eine andere Auskoppelschicht, z. B. ein durchsichtiges Substrat, kann die Oberflächenrauigkeit oder die Auskoppelstrukturen aufweisen.

Die Oberfläche der Auskoppelschicht ist vorzugsweise nicht überall, sondern mit Ausnahme eines Bereichs, in dem die Anschlussfläche angeordnet ist, aufgeraut. Das auf die Unterseite der Anschlussfläche einfallende Licht kann somit reflektiert werden. Dadurch ergibt sich eine verbesserte Lichtauskopplung.

In einer Variante ist eine Aussparung vorgesehen, die sich vertikal zum Schichtaufbau bis zur zweiten n-leitenden Schicht erstreckt. Die Aussparung ist zumindest teilweise mit einem dielektrischen Material gefüllt. Insbesondere sind die Seitenwände der Aussparung mit dem Dielektrikum ausgekleidet. Dadurch wird insbesondere die Erzeugung bzw. Ausbreitung der in der aktiven Zone erzeugten Strahlung in einem Bereich der Schichtenfolge verhindert, der unterhalb der Anschlussfläche liegt und folglich durch die Anschlussfläche abgeschattet ist. In diesem Fall können Stromverluste beim Betrieb des Leuchtdiodenchips gering gehalten werden, da der Stromverbrauch für die Erzeugung einer Strahlung, die nicht ausgekoppelt werden kann, vermieden werden.

Die Aussparung ist vorzugsweise als eine Sackloch-Aussparung ausgebildet. Der Boden der Aussparung reicht zumindest bis zur Grenzfläche der zweiten n-leitenden Schicht. Der Boden der Aussparung kann aber auch in einer Ebene liegen, die sich zwischen den beiden Grenzflächen der zweiten n-leitenden Schicht erstreckt. Ferner kann die Aussparung lediglich bis zur p-leitenden Schicht reichen. Erforderlich dabei ist jedoch, dass die Aussparung durch die aktive Schicht geführt ist.

Alternativ kann die Aussparung nicht in Form eines Sacklochs, sondern in Form einer Ringaussparung ausgeführt sein. Dann ist die Aussparung nicht zylinderförmig ausgeführt, sondern weist die Form eines Zylindermantels auf, wobei die Schichtenfolge in dem Innenbereich nicht ausgespart ist. Das hat den Vorteil, dass der Leuchtdiodenchip keine großflächige Aussparung aufweist, welche sich negativ auf die Stabilität des Leuchtdiodenchips auswirken könnte.

Erfindungsgemäß ist die Spiegelschicht über mindestens eine zweite Durchkontaktierung mit der zweiten n-leitenden Schicht leitend verbunden. Die Gesamtfläche eines an der Grenzfläche der mindestens einen zweiten Durchkontaktierung und der zweiten n-leitenden Schicht gebildeten elektrischen Kontakts beträgt vorzugsweise maximal 10%, in einer Variante maximal 5% der Grundfläche des Schichtaufbaus.

Die zweite Durchkontaktierung ist vorzugsweise von den ersten Durchkontaktierungen umgeben. Die Grundfläche der zweiten Durchkontaktierung ist vorzugsweise größer als diejenige der jeweiligen ersten Durchkontaktierung.

Die zweite Durchkontaktierung ist vorzugsweise in der Aussparung angeordnet. Zwischen der zweiten Durchkontaktierung und den halbleitenden Schichten des Schichtaufbaus ist in beliebiger Lateralrichtung ein Mantel aus einem dielektrischen Material angeordnet.

Die jeweilige erste Durchkontaktierung ist in einer Variante an eine leitende Fläche angeschlossen, die als die Spiegelschicht vorgesehen ist. Die zweite Durchkontaktierung ist vorzugsweise von den ersten Durchkontaktierungen elektrisch isoliert.

In einer weiteren Variante ist die zweite Durchkontaktierung von den ersten Durchkontaktierungen elektrisch isoliert. In diesem Fall ist die mit den ersten Durchkontaktierungen verbundene Spiegelschicht vorzugsweise mit Aussparungen versehen, in denen mit der zweiten Durchkontaktierung leitend verbundene Anschlussflächen angeordnet sind. Gemäß dieser Variante wird sowohl die erste n-leitende Schicht als auch die zweite n-leitende Schicht von nur einer Seite, und zwar von der Seite der Spiegelschicht elektrisch kontaktiert.

Zumindest ein Bereich der mit dem dielektrischen Material zumindest teilweise gefüllte Aussparung ist unterhalb der Anschlussfläche angeordnet. Die Grundfläche der Aussparung ist vorzugsweise größer als diejenige der Anschlussfläche. In einer lateralen Projektionsebene beträgt der Abstand zwischen den Kanten der Anschlussfläche und den Seitenflächen der Aussparung allseitig beispielsweise mindestens 5 Mikrometer, in einer Variante mindestens 10 Mikrometer.

Der Leuchtdiodenchip umfasst in einer Ausführungsform ein mit der Schichtenfolge fest verbundenes Substrat. Gemäß einer ersten Variante ist die zweite n-leitende Schicht zwischen dem Substrat und der p-leitenden Schicht angeordnet. Gemäß einer zweiten Variante ist die erste n-leitende Schicht zwischen dem Substrat und der aktiven Zone angeordnet.

Ein im optischen Bereich transparentes Substrat kann zur Auskoppelung der in der aktiven Zone erzeugten Strahlung verwendet werden. Das Substrat kann, muss aber nicht ein Wachstumssubstrat für die epitaktisch aufgewachsene Schichtenfolge sein.

Die Schichtenfolge kann darüber hinaus mit einem Trägersubstrat fest verbunden sein, das eine Abfolge von verschiedenen Metallschichten, darunter z. B. Ge, Mo, Ni, Cu, Ag, AgCu, Si und/oder AlN aufweist. Der Verbund der Spiegelschicht und der dielektrischen Schicht ist dabei zwischen dem Trägersubstrat und der Schichtenfolge angeordnet.

Um den Kontaktwiderstand elektrischer Kontakte an der Grenzfläche der Durchkontaktierungen und der Schichten der Schichtenfolge bzw. der Spiegelschicht gering zu halten, wird für die Durchkontaktierungen und die Spiegelschicht vorzugsweise ein Metall oder eine Metalllegierung mit einer relativ hohen elektrischen Leitfähigkeit wie z. B. Ag, Al usw. verwendet.

Im Folgenden wird das angegebene Bauelement und seine vorteilhaften Ausgestaltungen sowie Abwandlungen des Bauelements anhand von schematischen und nicht maßstabgetreuen Figuren erläutert. Es zeigen:
Figuren 1, 2, 3 im Querschnitt jeweils eine Abwandlung eines Leuchtdiodenchips mit zwei n-leitenden Schichten, einer dielektrischen Schicht und einer Spiegelschicht;
Figur 4 im Querschnitt eine Abwandlung eines Leuchtdiodenchips mit der zweiten n-leitenden Schicht als Auskoppelschicht;
Figur 5 die Ansicht der dielektrischen Schicht im Leuchtdiodenchip gemäß der Figur 4;
Figur 6 im Querschnitt ein Ausführungsbeispiel eines Leuchtdiodenchips mit einer Aussparung unterhalb einer Anschlussfläche;
Figur 7 die Ansicht der Aussparung und der Anschlussfläche von oben;
Figur 8 im Querschnitt ein Ausführungsbeispiel eines Leuchtdiodenchips, bei dem die beiden n-leitenden Schichten von einer Seite kontaktiert werden und bei dem ein transparentes Substrat zur Auskoppelung der Strahlung dient;
Figur 9 die Ansicht der dielektrischen Schicht im Leuchtdiodenchip gemäß der Figur 8;
Figur 10 die Ansicht der Unterseite des Leuchtdiodenchips gemäß der Figur 8;
Figur 11 im Querschnitt ein Ausführungsbeispiel eines Leuchtdiodenchips, bei dem die beiden n-leitenden Schichten von einer Seite kontaktiert werden und bei dem die zweite n-leitende Schicht zur Auskoppelung der Strahlung dient.

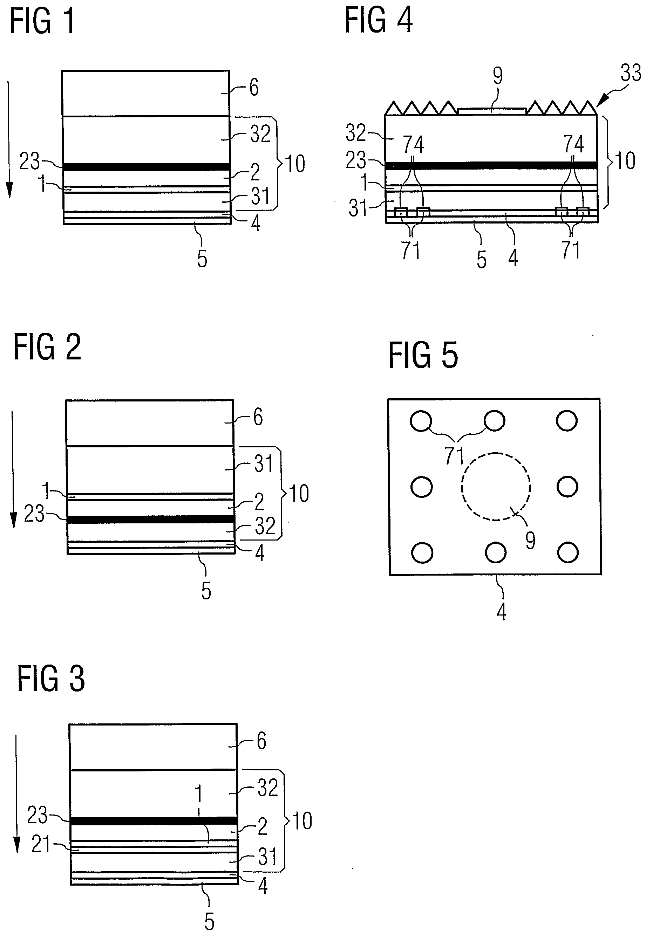

In den Figuren 1, 2, 3, 4, 6, 8, 11 ist jeweils eine Abwandlung oder ein Ausführungsbeispiel eines optoelektronischen Halbleiterchips mit einer Schichtenfolge 10 zur Strahlungserzeugung gezeigt. Die Schichtenfolge 10 umfasst eine p-leitende Schicht 2, eine erste n-leitende Schicht 31, eine zweite n-leitende Schicht 32 und eine strahlungserzeugende aktive Zone 1. Die aktive Zone 1 ist durch eine beispielsweise mit Indium dotierte Schicht gebildet, die zwischen der p-leitenden Schicht 2 und der ersten n-leitenden Schicht 31 angeordnet ist. Zwischen der p-leitenden Schicht 2 und der zweiten n-leitenden Schicht 32 ist ein Tunnelkontakt 23 gebildet.

Die Schichtenfolge 10 ist auf einem Substrat 6 vorzugsweise epitaktisch aufgewachsen. In den Figuren 1, 2, 3 ist die Wachstumsrichtung (von oben nach unten) mit einem Pfeil angedeutet.

In der Abwandlung gemäß der Figur 1 wird auf dem Substrat 6 zunächst die zweite n-leitende Schicht 32, danach die p-leitende Schicht, dann die lichterzeugende Schicht 1 und die erste n-leitende Schicht 31 aufgewachsen.
In der Abwandlung gemäß der Figur 2 wird auf dem Substrat 6 zunächst die erste n-leitende Schicht 31, danach die lichterzeugende Schicht 1, dann die p-leitende Schicht und die zweite n-leitende Schicht 32 aufgewachsen.

In der Abwandlung gemäß der Figur 3 wird auf dem Substrat 6 zunächst die zweite n-leitende Schicht 32, danach die p-leitende Schicht, dann die lichterzeugende Schicht 1, eine weitere p-leitende Schicht und auf dieser die erste n-leitende Schicht 31 aufgewachsen.

Die Wachstumsrichtung (nach unten) verläuft in den Abwandlungen gemäß den Figuren 1-3 antiparallel zur Lichtauskopplungsrichtung (nach oben). Die Wachstumsrichtung kann im Prinzip umgedreht werden, so dass die Wachstumsrichtung und die Lichtauskopplungsrichtung übereinstimmen bzw. parallel zueinander sind.

Die in den Figuren 1 bis 3 vorgestellten Schichtenfolgen 10 sind mit nachstehend erläuterten Abwandlungen und Ausführungsbeispielen des Leuchtdiodenchips beliebig kombinierbar.

Die Schichtenfolge 10 ist fest mit einem Spiegel verbunden, der eine durchsichtige dielektrische Schicht und eine Spiegelschicht 5 aufweist. Die dielektrische Schicht 4 wird auf der in Wachstumsrichtung gesehen obersten Schicht der Schichtenfolge (in Fig. 1, 3 die Schicht 31, in Fig. 2 die Schicht 32) aufgebracht, z. B. aufgedampft oder aufgesputtert. Die in einer Variante metallische Spiegelschicht 5 wird dann auf die dielektrische Schicht 4 aufgetragen, vorzugsweise aufgedampft.

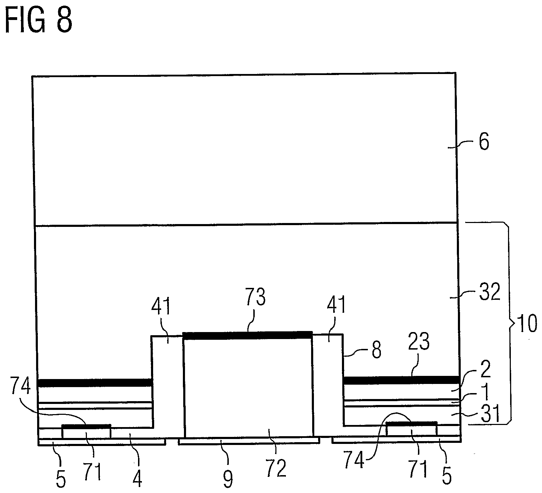

Alle Schichten der Schichtenfolge 10 sind durchsichtig. Das Substrat 6 ist vorzugsweise durchsichtig und kann wie z. B. in der Variante gemäß der Figur 8 zur Auskoppelung der Strahlung dienen. Im Prinzip besteht die Möglichkeit, das Substrat 6 zu entfernen und den in Fig. 1-3 gezeigten Schichtaufbau auf der Seite des Spiegels 4, 5 mit einem Trägersubstrat zu verbinden.

Die Schichten 4, 5 können im Prinzip mehrere übereinander liegende Teilschichten aufweisen. Dies gilt auch für das Substrat 6 und alle Schichten der Schichtenfolge 10.

In der Abwandlung gemäß der Figur 4 ist die erste n-leitende Schicht 31 mit der leitfähigen Spiegelschicht 5 über in der dielektrischen Schicht 4 angeordnete erste Durchkontaktierungen 71 leitend verbunden. Eine Ansicht der dielektrischen Schicht 4 mit den ersten Durchkontaktierungen 71 ist in der Figur 5 gezeigt.

Zur Erzeugung von ersten Durchkontaktierungen 71 werden in der dielektrischen Schicht 4 noch vor der Erzeugung der Spiegelschicht 5 unter Verwendung einer geeigneten Maske durchgehende Öffnungen geätzt. Die Öffnungen werden mit einem elektrisch leitenden Material mit einer hohen Leitfähigkeit gefüllt. Nach dem Füllen der Öffnungen wird die Spiegelschicht 5 aufgedampft.

Die zweite n-leitende Schicht 32 ist hier als eine Auskoppelschicht vorgesehen. Auf der zweiten n-leitenden Schicht 32 ist eine Anschlussfläche 9 angeordnet, die zur elektrischen Kontaktierung der Schicht 32 durch einen hier nicht gezeigten Anschlussdraht vorgesehen ist.

Auf der frei liegenden Oberfläche der zweiten n-leitenden Schicht 32 außerhalb des durch die Anschlussfläche 9 verdeckten Bereichs ist eine Auskoppelungsstruktur 33 angeordnet, die in einer Variante durch eine aufgeraute Oberfläche der Schicht 32 gebildet sein kann.

Die ersten Durchkontaktierungen 71 sind in einer lateralen Projektionsebene außerhalb des durch die Anschlussfläche 9 verdeckten Bereichs angeordnet, um eine Lichterzeugung unterhalb der Anschlussfläche 9 zu reduzieren. Dies wird in allen Varianten als Vorteil betrachtet.

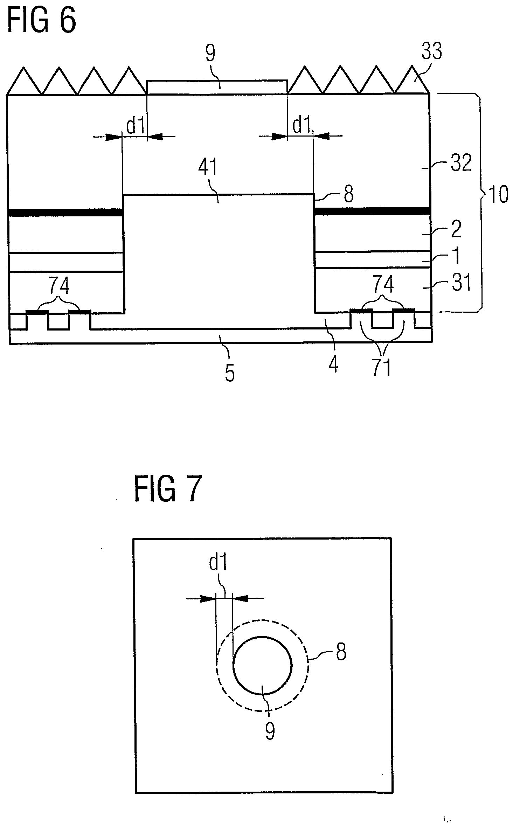

In der Figur 6 ist eine Weiterbildung der in der Figur 4 gezeigten Abwandlung gezeigt. In der Schichtenfolge 10 wird vor der Aufbringung der dielektrischen Schicht 4 eine Aussparung 8 in Form eines Sacklochs erzeugt. Zur Erzeugung der Aussparung 8 werden zumindest einige der Schichten der Schichtenfolge 10 unter Verwendung einer geeigneten Maske bis zu einer vorgegebenen Tiefe der in Lichtauskopplungsrichtung obersten n-leitenden Schicht, in Fig. 6 der Schicht 32, geätzt. Der Tunnelkontakt 23 wird durch die Aussparung 8 unterbrochen.

Alternativ kann die Aussparung 8 nicht in Form eines Sacklochs, wie in Fig. 6 dargestellt, sondern in Form einer Ringaussparung ausgeführt sein. Dann ist die Aussparung nicht wie in Fig. 6 zylinderförmig ausgeführt, sondern weist die Form eines Zylindermantels auf, wobei die Schichtenfolge 10 in dem Innenbereich nicht ausgespart ist (nicht dargestellt). Das hat den Vorteil, dass der Leuchtdiodenchip keine großflächige Aussparung aufweist, welche sich negativ auf die Stabilität des Leuchtdiodenchips auswirken könnte.

Die dabei gebildete Vertiefung wird mit einem dielektrischen Material 41 gefüllt. Danach wird die dielektrische Schicht 4 vorzugsweise aus dem gleichen dielektrischen Material aufgetragen.

Mit der elektrisch isolierenden Aussparung 8, die insbesondere in der hochleitenden, an die aktive Zone 1 angrenzenden Schicht 31 einen lateralen Stromfluss unterhalb der Anschlussfläche 9 unterbindet, kann eine Bestromung der Schichtenfolge und somit auch die Lichterzeugung unterhalb der Anschlussfläche vermieden werden. Somit gelingt es, den Energieverbrauch für die Strahlung, die wegen der Abschattung durch die Anschlussfläche 9 nicht ausgekoppelt sein könnte, zu reduzieren. Somit wird die Auskoppeleffizient bzw. der Wirkungsgrad des Chips erhöht.

Eine "Deaktivierung" des Materials der Schichtenfolge im Sinne der unterbrochenen Bestromung unterhalb der Anschlussfläche kann alternativ durch eine Materialmodifikation erreicht werden, wobei ein unterhalb der Anschlussfläche liegender Bereich der jeweiligen halbleitenden Schicht elektrisch isolierend gemacht wird.

In einer in Fig. 7 gezeigten lateralen Projektionsebene wird ein gewisser Abstand d1 zwischen den Kanten der Anschlussfläche 9 und den Seitenflächen der Aussparung 8 vorzugsweise allseitig eingehalten. Der Abstand d1 beträgt z. B. 5-10 Mikrometer.

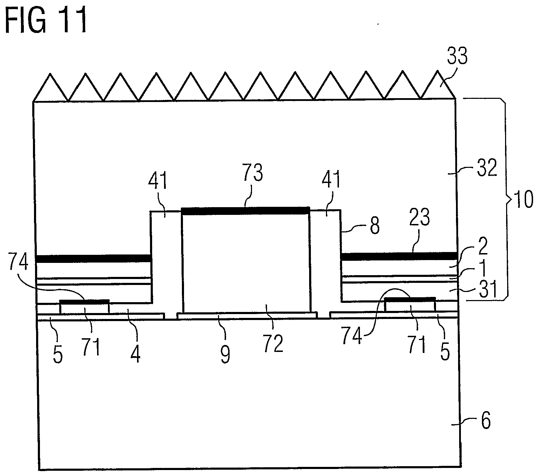

In den Ausführungsbeispielen gemäß den Figuren 8 und 11 werden beide n-leitende Schichten 31, 32 von der Seite des Spiegels 4, 5 kontaktiert. In der Aussparung 8 wird dafür eine zweite Durchkontaktierung 72 erzeugt, die sich bis zum Boden der Aussparung bzw. bis in das Innere der letzten hochleitenden Schicht 32 erstreckt. An der Grenzfläche der Durchkontaktierung 72 und der Schicht 32 ist ein vorzugsweise niederohmiger elektrischer Kontakt 73 gebildet.

Zur Erzeugung von zweiten Durchkontaktierungen 72 wird die Schicht 4 und das dielektrische Material 41 der Aussparung 8 unter Verwendung einer geeigneten Maske zumindest bis zum Boden der Aussparung 8 geätzt. Die dabei gebildete Vertiefung oder Öffnung wird mit einem elektrisch leitenden Material mit einer hohen Leitfähigkeit gefüllt.

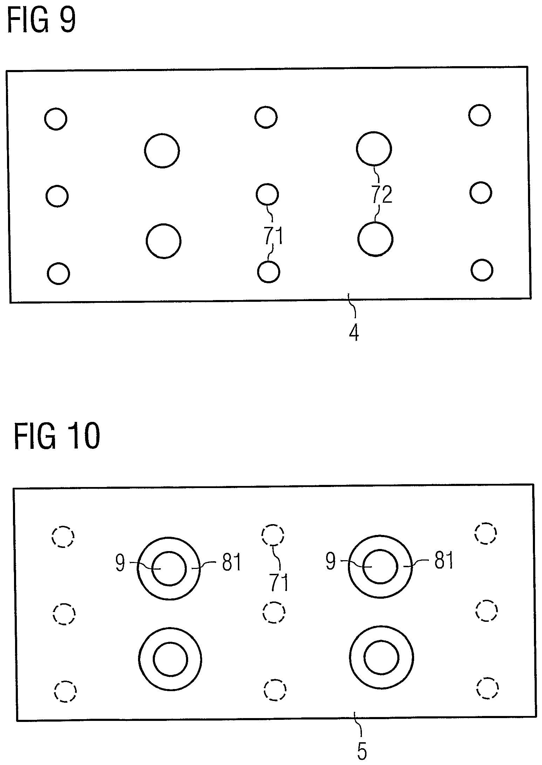

Die Anschlussfläche 9 ist in diesem Fall auf der Unterseite der zweiten Durchkontaktierung 72 erzeugt. Die jeweilige Anschlussfläche 9 ist in einer Aussparung 81 der Spiegelschicht 5 angeordnet, siehe Fig. 10.

Die Anordnung der Durchkontaktierungen 71, 72 in der dielektrischen Schicht 4 ist in der Figur 9 zu sehen.

Zur Verbesserung der elektrischen Kontakte 73, 74 der Durchkontaktierungen 71, 72 und der n-leitenden Schichten 31, 32 wird für die Durchkontaktierungen ein hochleitendes Material verwendet, z. B. Aluminium und/oder Silber, das in der Lage ist, eine niederohmige elektrische Verbindung zwischen der jeweiligen Durchkontaktierung und der jeweiligen n-leitenden Schicht und eine gute Reflektivität zu gewährleisten. Der Reflexionskoeffizient der elektrischen Kontakte 73, 74 beträgt vorzugsweise mindestens 90%.
In dem Ausführungsbeispiel gemäß der Figur 8 dient das in diesem Fall transparente Substrat 6 zur Auskoppelung der Strahlung. In dem Ausführungsbeispiel gemäß der Figur 11, die sich auch durch eine einseitige Kontaktierung der n-leitenden Schichten 31, 32 auszeichnet, wird die Strahlung aus der zweiten n-leitenden Schicht 32 ausgekoppelt. Der Schichtaufbau des Leuchtdiodenchips und der Typ der Lichtauskoppelung entspricht in diesem Fall der Figur 4 oder 6.

Der Verbund der Schichtenfolge 10 und des Spiegels 4, 5 ist in den Figuren 4, 6 und 11 mit dem in Fig. 11 gezeigten Trägersubstrat 6 verbunden. Zur Verbindung der Schichtenfolge mit dem Spiegel kommt ein Waferbonding oder eine in den Figuren nicht gezeigte Verbindungsschicht in Betracht.

Auch wenn in den Figuren 4, 6, 8, 11 stets die zweite n-leitende Schicht 32 als die in Auskopplungsrichtung oberste Schicht gezeigt ist, ist es im Prinzip möglich, die Reihenfolge der Schichten der Schichtenfolge 10 umzukehren, wie z. B. in der Fig. 2. In diesem Fall wird die erste n-leitende Schicht 31 durch die zweiten Durchkontaktierungen 72 und die erste n-leitende Schicht 31 durch die ersten Durchkontaktierungen 71 elektrisch kontaktiert.

## Patentansprüche

1. Leuchtdiodenchip
- mit einer Schichtenfolge (10), die mindestens eine n-leitende Schicht (31, 32) aufweist, wobei die mindestens eine n-leitende Schicht (31, 32) eine erste n-leitende Schicht (31) und eine zweite n-leitende Schicht (32) umfasst, wobei zwischen der ersten (31) und der zweiten n-leitenden Schicht (32) eine p-leitende Schicht (2) und eine strahlungserzeugende aktive Zone (1) angeordnet sind,
- mit einem Spiegel, der eine elektrisch leitende Spiegelschicht (5) und mindestens eine dielektrische Schicht (4) umfasst,
- mit einer Aussparung (8), die sich vertikal zum Schichtaufbau von der Spiegelschicht (5) durch die erste n-leitende Schicht (31), durch die aktive Zone (1) und die p-leitende Schicht (2) bis hin zur zweiten n-leitenden Schicht (32) erstreckt,
- mit einer Durchkontaktierung (72), die in der Aussparung (8) angeordnet ist,
- wobei die erste n-leitende Schicht (31) dem Spiegel zugewandt ist,
- wobei die mindestens eine dielektrische Schicht (4) zwischen der n-leitenden Schicht (31) und der elektrisch leitenden Spiegelschicht (5) angeordnet ist,
- wobei die elektrisch leitende Spiegelschicht (5) leitend mit der ersten n-leitenden Schicht (31) verbunden ist,
- wobei die Durchkontaktierung (72) mit der zweiten n-leitenden Schicht (32) leitend verbunden ist.

2. Leuchtdiodenchip nach Anspruch 1,
- wobei die Schichtenfolge (10) auf Basis von GaN gebildet ist.

3. Leuchtdiodenchip nach Anspruch 1 oder 2,
- wobei zwischen der p-leitenden Schicht (2) und der zweiten n-leitenden Schicht (32) ein Tunnelkontakt gebildet ist.

4. Leuchtdiodenchip nach einem der vorhergehenden Ansprüche,
- wobei die Spiegelschicht (5) mit der ersten n-leitenden Schicht (31) über erste Durchkontaktierungen (71) leitend verbunden ist, die in der dielektrischen Schicht (4) angeordnet sind.

5. Leuchtdiodenchip nach einem der vorhergehenden Ansprüche,
- wobei die Aussparung teilweise mit einem dielektrischen Material gefüllt ist.

6. Leuchtdiodenchip nach einem der vorhergehenden Ansprüche,
- wobei die Spiegelschicht über mindestens die in der Aussparung angeordnete Durchkontaktierung (72) mit der zweiten n-leitenden Schicht leitend verbunden ist,
- wobei zwischen der Seitenfläche der in der Aussparung angeordneten Durchkontaktierung (72) und halbleitenden Schichten der Schichtenfolge (10) ein umlaufender Mantel (41) aus einem dielektrischen Material angeordnet ist.

7. Leuchtdiodenchip nach einem der vorhergehenden Ansprüche,
- wobei die in der Aussparung angeordnete Durchkontaktierung (72) an eine leitende Fläche angeschlossen ist, die als die Spiegelschicht vorgesehen ist.

8. Leuchtdiodenchip nach mindestens Anspruch 4,
- wobei die jeweilige erste Durchkontaktierung (71) an eine leitende Fläche angeschlossen ist, die als die Spiegelschicht (5) vorgesehen ist.

9. Leuchtdiodenchip nach einem der vorhergehenden Ansprüche,
- wobei die Aussparung (8) unterhalb einer Anschlussfläche (9) angeordnet ist,
- wobei die Grundfläche der Aussparung (8) größer ist als diejenige der Anschlussfläche (9), und
- wobei in einer lateralen Projektionsebene der Abstand zwischen den Kanten der Anschlussfläche (9) und den Seitenflächen der Aussparung (8) mindestens 5 Mikrometer beträgt.

10. Leuchtdiodenchip
- mit einer Schichtenfolge (10), die folgende Schichten aufweist: zwei n-leitende Schichten, eine strahlungserzeugende aktive Zone und eine p-leitende Schicht, wobei die strahlungserzeugende aktive Zone (1) und die p-leitende Schicht (2) zwischen den zwei n-leitenden Schichten (31, 32) angeordnet sind,
- wobei auf der in Auskopplungsrichtung obersten der n-leitenden Schichten eine Anschlussfläche (9) angeordnet ist,
- wobei der Leuchtdiodenchip einen Spiegel aufweist, der eine elektrisch leitende Spiegelschicht (5) und mindestens eine zwischen der untersten n-leitenden Schicht (31) und der Spiegelschicht (5) angeordnete dielektrische Schicht (4) umfasst, wobei die elektrisch leitende Spiegelschicht (5) leitend mit der untersten n-leitenden Schicht (31) verbunden ist,
- wobei in der Schichtenfolge (10) zumindest unterhalb der Anschlussfläche (9) eine Aussparung (8) ausgebildet ist, die sich in Auskopplungsrichtung zumindest bis zur obersten der n-leitenden Schichten erstreckt,
- wobei die Aussparung (8) zumindest im Bereich ihrer Mantelflächen durch ein dielektrisches Material (41) aus gekleidet ist,
- wobei der Boden der Aussparung (8) in Vertikalrichtung von der Anschlussfläche (9) beabstandet ist.

## Claims

1. Light emitting diode chip
- with a layer sequence (10) comprising at least one n-conductive layer (31, 32), said at least one n-conductive layer (31, 32) comprising a first n-conductive layer (31) and a second n-conductive layer (32), wherein a p-conductive layer (2) and a radiation-generating active zone (1) are disposed between said first (31) and second n-conductive layer (32),
- with a mirror, which has an electrically conductive mirror layer (5) and at least one dielectric layer (4),
- with a recess (8), which extends vertically to the layer sequence from the mirror layer (5) through the first n-conductive layer (31), through the active zone (1) and the p-conductive layer (2) to the second n-conductive layer (32),
- with a through-connection (72) arranged in the recess (8),
- wherein the first n-conductive layer (31) faces the mirror,
- wherein the at least one dielectric layer (4) is arranged between the n-conductive layer (31) and the electrically conductive mirror layer (5),
- wherein the electrically conductive mirror layer (5) is conductively connected to the first n-conductive layer (31),
- wherein the through-connection (72) is conductively connected to the second n-conductive layer (32).

2. A light-emitting diode chip according to claim 1,
- wherein the layer sequence (10) is based on GaN.

3. A light-emitting diode chip according to claim 1 or 2,
- wherein a tunnel contact is formed between the p-conductive layer (2) and the second n-conductive layer (32) .

4. A light-emitting diode chip according to one of the previous claims,
- wherein the mirror layer (5) is conductively connected to the first n-conductive layer (31) via first through-connections (71) arranged in the dielectric layer (4).

5. A light-emitting diode chip according to one of the previous claims,
- wherein the recess is partially filled with a dielectric material.

6. A light emitting diode chip according to one of the previous claims,
- wherein the mirror layer is conductively connected to the second n-conductive layer via at least the through-connection (72) arranged in the recess,
- wherein a circumferential jacket (41) of a dielectric material is arranged between the side surface of the through-connection (72) arranged in the recess and semi-conductive layers of the layer sequence (10).

7. A light emitting diode chip according to one of the preceding claims,
- wherein the through-connection (72) arranged in the recess is connected to a conductive surface provided as the mirror layer.

8. A light emitting diode chip according to at least claim 4,
- wherein the respective first through-connection (71) is connected to a conductive surface provided as the mirror layer (5).

9. A light emitting diode chip according to one of the preceding claims,
- wherein the recess (8) is arranged below a connection area (9),
- wherein the base area of the recess (8) is larger than that of the connection area (9), and
- wherein, in a lateral projection plane, the distance between the edges of the connection area (9) and the side surfaces of the recess (8) is at least 5 micrometers.

10. A light emitting diode chip
- with a layer sequence (10) which has the following layers: two n-conductive layers, a radiation-generating active zone and a p-conductive layer, the radiation-generating active zone (1) and the p-conductive layer (2) being arranged between the two n-conductive layers (31, 32),
- wherein a connection area (9) is arranged on the uppermost of the n-conductive layers in the decoupling direction,
- wherein the light emitting diode chip has a mirror comprising an electrically conductive mirror layer (5) and at least one dielectric layer (4) between the lowest n-conductive layer (31) and the mirror layer (5), the electrically conductive mirror layer (5) being conductively connected to the lowest n-conductive layer (31),
- wherein a recess (8) is formed in the layer sequence (10) at least below the connection area (9) and extends in the decoupling direction at least as far as the uppermost of the n-conductive layers,
- wherein the recess (8) is lined by a dielectric material (41) at least in the region of its lateral surfaces,
- wherein the bottom of the recess (8) is spaced vertically from the connection area (9).

## Revendications

1. Puce de diode électroluminescente
- dotée d'une séquence de couches (10) qui présente au moins une couche conductrice de type N (31, 32), l'au moins une couche conductrice de type N (31, 32) comprenant une première couche conductrice de type N (31) et une deuxième couche conductrice de type N (32), une couche conductrice de type P (2) et une zone active génératrice de rayonnement (1) étant agencées entre la première (31) et la deuxième couche conductrice de type N (32),
- dotée d'un miroir qui comprend une couche miroir électroconductrice (5) et au moins une couche diélectrique (4),
- dotée d'un évidement (8) qui s'étend, à la verticale de la structure en couches, de la couche miroir (5) à la deuxième couche conductrice de type N (32) en passant par la première couche conductrice de type N (31) puis par la zone active (1) et par la couche conductrice de type P (2),
- dotée d'une connexion traversante (72) qui est agencée dans l'évidement (8),
- la première couche conductrice de type N (31) étant tournée vers le miroir,
- l'au moins une couche diélectrique (4) étant agencée entre la première couche conductrice de type N (31) et la couche miroir électroconductrice (5),
- ladite couche miroir électroconductrice (5) étant reliée de manière conductrice à la première couche conductrice de type N (31),
- la connexion traversante (72) étant reliée de manière conductrice à la deuxième couche conductrice de type N (32).

2. Puce de diode électroluminescente selon la revendication 1,
- la séquence de couches (10) étant formée à base de GaN.

3. Puce de diode électroluminescente selon la revendication 1 ou 2,
- un contact à effet de tunnel étant formé entre la couche conductrice de type P (2) et la deuxième couche conductrice de type N (32).

4. Puce de diode électroluminescente selon l'une quelconque des revendications précédentes,
- la couche miroir (5) étant reliée de manière conductrice à la première couche conductrice de type N (31) par le biais de premières connexions traversantes (71) qui sont agencées dans la couche diélectrique (4).

5. Puce de diode électroluminescente selon l'une quelconque des revendications précédentes,
- l'évidement étant partiellement rempli d'un matériau diélectrique.

6. Puce de diode électroluminescente selon l'une quelconque des revendications précédentes,
- la couche miroir étant reliée de manière conductrice à la deuxième couche conductrice de type N par le biais d'au moins la connexion traversante (72) agencée dans l'évidement,
- une enveloppe périphérique (41) en matériau diélectrique étant agencée entre la face latérale de la connexion traversante (72) agencée dans l'évidement et des couches semi-conductrices de la séquence de couches (10) .

7. Puce de diode électroluminescente selon l'une quelconque des revendications précédentes,
- la connexion traversante (72) agencée dans l'évidement étant raccordée à une surface conductrice qui est prévue pour être la couche miroir.

8. Puce de diode électroluminescente selon au moins la revendication 4,
- la première connexion traversante (71) respective étant raccordée à une surface conductrice qui est prévue pour être la couche miroir (5).

9. Puce de diode électroluminescente selon l'une quelconque des revendications précédentes,
- l'évidement (8) étant agencé au-dessous d'une surface de raccordement (9),
- la surface de base de l'évidement (8) étant plus grande que celle de la surface de raccordement (9), et
- dans un plan de projection latéral, la distance entre les bords de la surface de raccordement (9) et les faces latérales de l'évidement (8) étant au moins de 5 microns.

10. Puce de diode électroluminescente
- dotée d'une séquence de couches (10) qui présente les couches suivantes : deux couches conductrices de type N, une zone active génératrice de rayonnement et une couche conductrice de type P, ladite zone active génératrice de rayonnement (1) et la couche conductrice de type P (2) étant agencées entre les deux couches conductrices de type N (31, 32),
- une surface de raccordement (9) étant agencée sur la couche supérieure, dans le sens de dissociation, des couches conductrices de type N,
- la puce de diode électroluminescente présentant un miroir qui comprend une couche miroir électroconductrice (5) et au moins une couche diélectrique (4) agencée entre la couche conductrice de type N (31) inférieure et la couche miroir (5), la couche miroir électroconductrice étant reliée de manière conductrice à la couche conductrice de type N (31) inférieure,
- étant constitué dans la séquence de couches (10), au moins en deçà de la surface de raccordement (9), un évidement (9) qui s'étend, dans le sens de dissociation, au moins jusqu'à la couche supérieure des couches conductrices de type N,
- l'évidement (8) étant revêtu, au moins au niveau de ses surfaces d'enveloppe, par un matériau diélectrique (41),
- le fond de l'évidement (8) étant espacé de la surface de raccordement (9) dans le sens vertical.
